# EUROPEAN PATENT SPECIFICATION

(11) **EP 2 587 550 B1**
(45) Date of publication and mention of the grant of the patent: **13.06.2018**
(21) Application number: 11798132.4
(22) Date of filing: 21.06.2011
(51) Int. Cl.: H01L 31/05, H01L 31/054, H01L 31/048

(54) **SOLAR CELL MODULE AND METHOD FOR MANUFACTURING A SOLAR CELL MODULE**
SOLARZELLENMODUL UND VERFAHREN ZUR HERSTELLUNG EINES SOLARZELLENMODULS
MODULE DE CELLULES SOLAIRES ET PROCÉDÉ DE FABRICATION DE MODULE DE CELLULES SOLAIRES

(30) Priority: 25.06.2010 JP 2010145163
(43) Date of publication of application: 01.05.2013
(73) Proprietor: Panasonic Intellectual Property Management Co., Ltd., Osaka-shi, Osaka 540-6207 (JP)
(72) Inventor: SUMITOMO, Koutarou, Moriguchi-shi Osaka 570-8677 (JP)
(74) Representative: Addiss, John William
(86) International application number: PCT/JP2011/064149
(87) International publication number: WO 2011/162248

(56) References cited:
- WO-A1-2011/004950
- WO-A2-2009/126745
- JP-A- 2004 055 596
- JP-A- 2004 055 596
- JP-A- 2004 200 515
- JP-A- 2006 013 406
- JP-A- 2007 273 857
- JP-A- 2007 273 857
- US-A1- 2007 125 415

## Description

### TECHNICAL FIELD

The invention relates to a solar cell module and a method of manufacturing a solar cell module, and particularly relates to a solar cell module including a wiring material and a method of manufacturing such a solar cell module.

### BACKGROUND ART

Heretofore, there has been known a solar cell module including a wiring material. Such a solar cell module is disclosed in JP2004-281797, for example.

Aforementioned JP2004-281797 discloses a solar cell module including a pair of solar cells arranged next to each other, and a connection tab (wiring material) having a front surface connected to a back surface of one of the solar cells and a back surface connected to a front surface of the other solar cell. Note that although not specified in JP2004-281797, the connection tab is considered to be a general connection tab having flat surfaces on both sides.

On the other hand, as the wiring material, there is used a diffuse reflection wiring material whose front surface is formed to have a texture or indentations in some cases. The diffuse reflection wiring material is configured to diffuse radiated light by reflecting the radiated light on inclined surfaces of the texture to various directions.

US 2007/0125415 describes a crystalline silicon PV module having a flat bus wire that is patterned with shallow v-shaped grooves using metal forming techniques, such as rolling, stamping and drawing. The grooves are designed so that incident light is reflected up toward the glass superstrate of the module at an internal interface angle that is large enough (typically greater than about 40 DEG) so that the light undergoes total internal reflection at the glass-air interface and is reflected onto the solar cell. A photocurrent resulting from the normal impingement of light on a proto-type of such a patterned bus bar was found to be at least 70% of the photocurrent resulting from the direct impingement on the active cell area of the same light source. A typical face angle of about 60 DEG was found to provide TIR for at least 50% of the light that strikes the bus wire as omni-directional illumination. Substantially all of the light that strikes the cover external surface at any external interface angle less than about 30 degrees relative to the perpendicular to the cover surface was found to experience TIR. Typical face size was between 5 and 150 microns, with spacing between crests of about twice that range. In one example described therein, grooves are not formed on the portion of the bus wire that connects to the bottom of the adjacent cell, so that the grooves do not interfere with soldering to the adjacent solar cell.

### PRIOR ART DOCUMENT

### PATENT DOCUMENT

Patent Document 1: JP2004-281797

### SUMMARY OF THE INVENTION

### PROBLEM TO BE SOLVED BY THE INVENTION

However, in a case of connecting the front surface of the diffuse reflection wiring material and a back surface of a solar cell, a contact area between the front surface of the diffuse reflection wiring material and the back surface of the solar cell tends to be small due to the texture formed in the front surface of the diffuse reflection wiring material. Hence, the front surface of the diffuse reflection wiring material and the back surface of the solar cell might not be connected firm enough in some cases. This lowers the bonding strength between the diffuse reflection wiring material and the solar cell, causing decrease in yield.

The invention is made in view of the above problem, and one objective of the invention is to provide a solar cell module and a method of manufacturing a solar cell module which can suppress decrease in yield.

### MEANS FOR SOLVING THE PROBLEM

According to a first aspect of the present invention there is provided a solar cell module according to claim 1.

A method of manufacturing a solar cell module according to a second aspect of the invention is a method of manufacturing a solar cell module including a first solar cell and a second solar cell disposed adjacent to each other, and a diffuse reflection wiring material having a front surface on which a textured diffuse-reflection portion for diffusely reflecting light is formed and a back surface, the back surface being connected to a front surface side of the first solar cell, the front surface being connected to one of a back surface of the second solar cell and an intermediate wiring material, the method comprising the steps of: crushing the texture in a predetermined area of the diffuse-reflection portion by applying at least one of pressure and heat, such that the texture in the predetermined area approximates a flat surface; and connecting the one of the back surface of the second solar cell and the intermediate wiring material to the front surface of the diffuse reflection wiring material in the area where the texture of the diffuse-reflection portion is crushed, while connecting the front surface of the first solar cell and the back surface of the diffuse reflection wiring material in an area where the texture of the diffuse-reflection portion is not crushed.

### EFFECTS OF THE INVENTION

The solar cell module according to the first aspect and the method of manufacturing a solar cell module according to the second aspect can enlarge a contact area between the front surface of the diffuse reflection wiring material and the back surface of the solar cell or the intermediate wiring material. Thus, it is possible to suppress lowering in the bonding strength between the diffuse reflection wiring material and the solar cell or the intermediate wiring material, to thereby suppress decrease in yield.

Moreover, the method of manufacturing a solar cell module according to the second aspect can form a diffuse reflection wiring material with the texture having different heights in the thickness direction by use of a diffuse reflection wiring material on which a textured diffuse-reflection portion is uniformly formed.

### BRIEF DESCRIPTION OF THE DRAWINGS

[Fig. 1] Fig. 1 is a plan view of a front surface side of a solar cell module of a first embodiment of the invention.
[Fig. 2] Fig. 2 is a plan view of a back surface side of the solar cell module of the first embodiment of the invention.
[Fig. 3] Fig. 3 is a cross section of the solar cell module near its end portion on a Y1 side, taken along a line 200-200 of Figs. 1 and 2.
[Fig. 4] Fig. 4 is an enlarged cross section of a solar cell group near its end portion on the Y1 side, taken along the line 200-200 of Figs. 1 and 2.
[Fig. 5] Fig. 5 is a cross section of the solar cell module near its end portion on a Y2 side, taken along the line 200-200 of Figs. 1 and 2.
[Fig. 6] Fig. 6 is an enlarged cross section of the solar cell group near its end portion on the Y2 side, taken along the line 200-200 of Figs. 1 and 2.
[Fig. 7] Fig. 7 is an enlarged cross section of the solar cell group taken along a line 300-300 of Figs. 3 and 5.
[Fig. 8] Fig. 8 is an enlarged cross section of the solar cell group taken along a line 400-400 of Fig. 4.
[Fig. 9] Fig. 9 is a cross section showing how a bent portion of diffuse reflection tab wiring of the first embodiment of the invention is formed.
[Fig. 10] Fig. 10 is a cross section taken along a line 500-500 of Fig. 9, showing how the bent portion of the diffuse reflection tab wiring is formed.
[Fig. 11] Fig. 11 is a cross section showing how a flat portion of the diffuse reflection tab wiring of the first embodiment of the invention is formed.
[Fig. 12] Fig. 12 is a cross section taken along a line 600-600 of Fig. 11, showing how the flat portion of the diffuse reflection tab wiring is formed.
[Fig. 13] Fig. 13 is a cross section of a solar cell module of a second embodiment of the invention near its end portion on the Y1 side.
[Fig. 14] Fig. 14 is an enlarged cross section of a solar cell group of the second embodiment of the invention near its end portion on the Y1 side.
[Fig. 15] Fig. 15 is a cross section of the solar cell module of the second embodiment of the invention near its end portion on the Y2 side.
[Fig. 16] Fig. 16 is an enlarged cross section of the solar cell group of the second embodiment of the invention near its end portion on the Y2 side.
[Fig. 17] Fig. 17 is an enlarged cross section of the solar cell group taken along a line 700-700 of Fig. 14.
[Fig. 18] Fig. 18 is an enlarged cross section of the solar cell group taken along a line 800-800 of Fig. 14.

### MODES FOR CARRYING OUT THE INVENTION

A description is given below of embodiments of the invention with reference to the drawings.

### (First Embodiment)

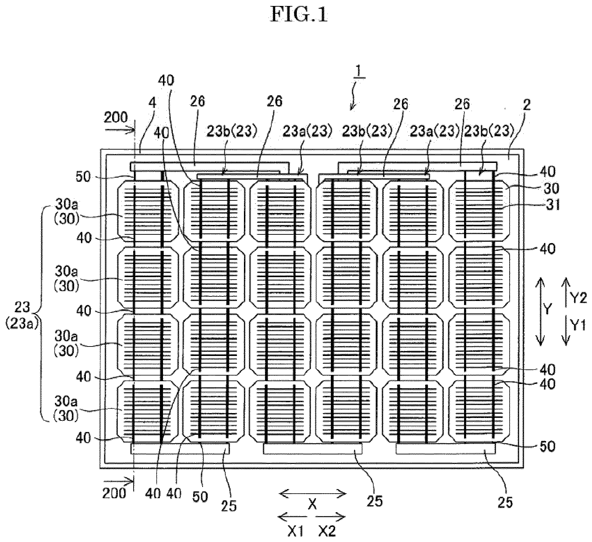

First, a configuration of solar cell module 1 of a first embodiment is described with reference to Figs. 1 to 8.

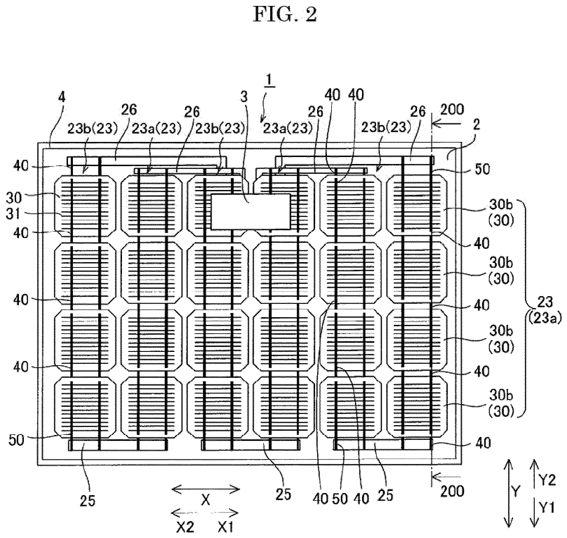

As shown in Figs. 1 and 2, solar cell module 1 of the first embodiment of the invention includes solar cell panel 2 which is a plate shape, terminal box 3 (see Fig. 2) fixed on a back surface side of solar cell panel 2, and metal frame 4 supporting side surfaces of solar cell panel 2. Terminal box 3 is provided to collect electric power generated in solar cell panel 2.

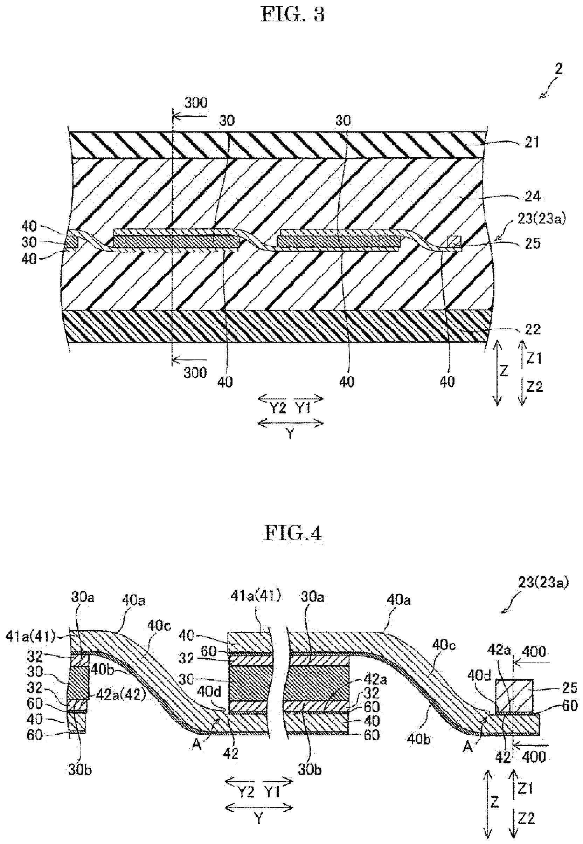

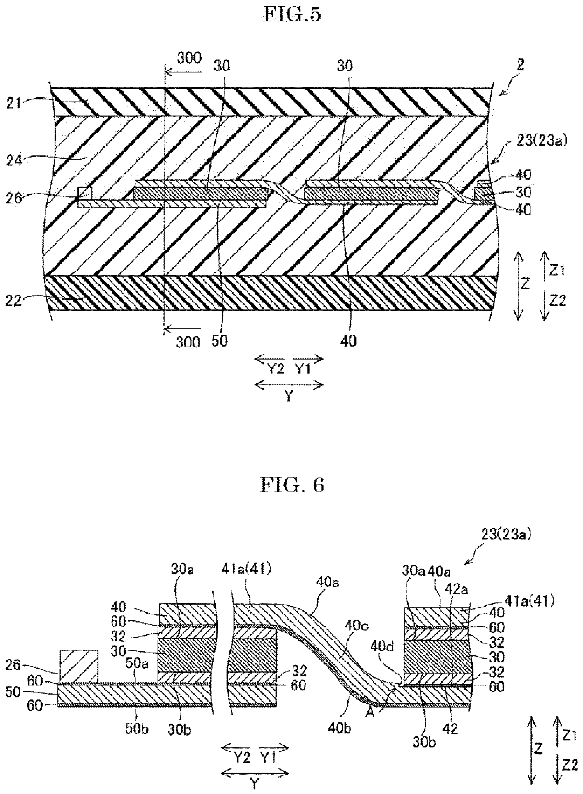

Additionally, as shown in Figs. 3 and 5, solar cell panel 2 includes front cover 21, back cover 22, six solar cell groups 23 (see Fig. 1), and sealant 24. Front cover 21 is formed of a transparent member such as a glass plate or an acrylic plate. Back cover 22 is formed of a weatherproof resin film or the like such as polyethylene terephthalate (PET). Each of the six solar cell groups 23 is disposed between front cover 21 and back cover 22, and formed of multiple solar cells 30 electrically connected in series. Sealant 24 is provided between front cover 21 and solar cell 30 as well as between back cover 22 and solar cell 30 in such a manner as to cover solar cell groups 23. Note that solar cell 30 is an example of "first solar cell" and "second solar cell" of the invention.

As shown in Figs. 1 and 2, solar cell panel 2 is formed with transmitting wiring 25, as an intermediate wiring or a relay wiring, which connects neighboring solar cell groups 23 on the Y1 side and with transmitting wiring 26, as an intermediate wiring or a relay wiring, which connects solar cell groups 23 and terminal box 3 on the Y2 side. Note that transmitting wiring 25 and transmitting wiring 26 are an example of "intermediate wiring material" of the invention.

Each of front surface 30a (see Fig. 1) and back surface 30b (see Fig. 2) of solar cell 30 is provided with multiple finger electrodes 31 extending in an X direction. In addition, as shown in Figs. 4 and 6, each of front surface 30a and back surface 30b of solar cell 30 is provided with bus bar electrodes 32 extending in a direction (Y direction) substantially orthogonal to finger electrodes 31. Note that finger electrodes 31 and bus bar electrodes 32 are not illustrated in Figs. 3 and 5, since finger electrodes 31 and bus bar electrodes 32 have small thicknesses.

As shown in Figs. 4 and 6, in solar cell group 23a located in an end portion of solar cell panel 2 on an X1 side (see Figs. 1 and 2), bus bar electrode 32 on back surface 30b (Z2 side) of one solar cell 30 on the Y1 side of solar cells 30 which are disposed next to each other is connected, with diffuse reflection tab wiring 40 having solder 60, to bus bar electrode 32 on front surface 30a (Z1 side) of the other solar cell 30 on the Y2 side. Diffuse reflection tab wiring 40 is arranged from the vicinity of Y1 side end portion of solar cell 30 to the vicinity of Y2 side end portion thereof. Here, diffuse reflection tab wiring 40 has a function of diffusely reflecting light on its front surface 40a. This point is later described in detail. Note that diffuse reflection tab wiring 40 is an example of "diffuse reflection wiring material" of the invention.

As shown in Fig. 4, transmitting wiring 25 disposed in the Y1 side end portion is connected to bus bar electrode 32 on front surface 30a of solar cell 30 located in Y1 side end of solar cell group 23, with diffuse reflection tab wiring 40 having solder 60 in between. As shown in Fig. 6, transmitting wiring 26 disposed in Y2 side end portion is connected to bus bar electrode 32 disposed on back surface 30b of solar cell 30 located in the Y2 side end portion of solar cell group 23, with plate-shaped back-surface tab electrode 50 with solder 60 in between.

As shown in Figs. 1 and 2, solar cell group 23b arranged next to solar cell group 23a in the end portion of solar cell panel 2 on the X1 side is configured to have the same connection structure as that of the solar cell group 23a, as solar cell group 23b being viewed from the Y1 side toward the Y2 side and solar cell group 23a being viewed from the Y2 side toward the Y1 side. To be specific, in solar cell group 23b, unillustrated bus bar electrode on back surface 30b of solar cell 30 on the Y2 side and unillustrated bus bar electrode on front surface 30a of solar call 30 on the Y1 side are connected by diffuse reflection tab wiring 40 with unillustrated solder in between. Additionally, transmitting wiring 26 disposed in the Y2 side end portion and unillustrated bus bar electrode on front surface 30a of solar cell 30 located in the Y2 side end portion of solar cell group 23 are connected with diffuse reflection tab wiring 40 having unillustrated solder in between. Meanwhile, transmitting wirings 25 disposed in the Y1 side end portion and unillustrated bus bar electrodes on back surface 30b of solar cell 30 located in the Y1 side end portion of solar cell group 23 are connected with plate-shaped back-surface tab electrodes 50 having unillustrated solder in between.

In solar cell panel 2, solar cell groups 23a and solar cell groups 23b are alternately arranged in the X direction. Note that since solar cell group 23a and solar cell group 23b have substantially the same configuration, the configuration of solar cell group 23a is described below.

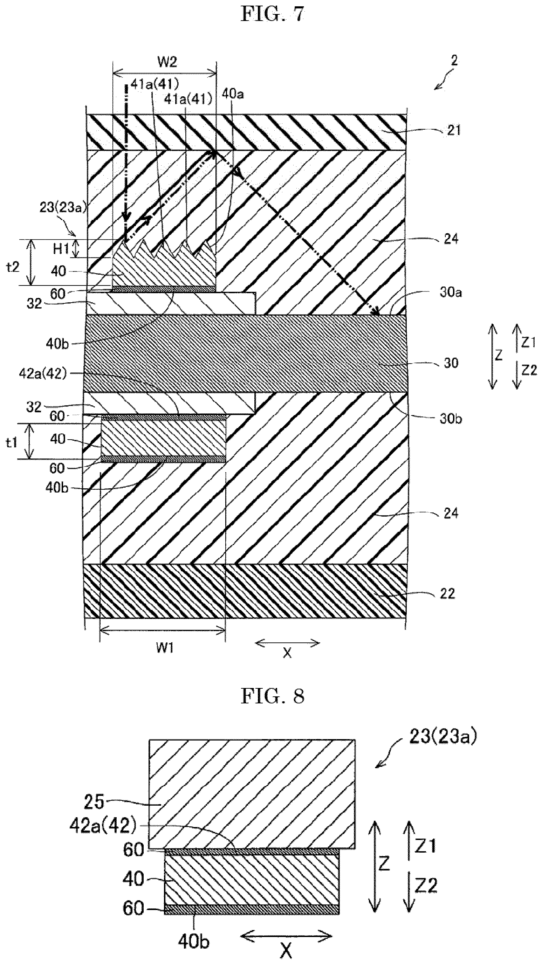

As shown in Fig. 7, front surface 40a (Z1 side) of diffuse reflection tab wiring 40 is formed with textured portion 41 or an uneven portion in which multiple adjacent convex portions 41a are provided to form a texture or indentations. Note that convex portion 41a has a triangular cross section. Additionally, a surface of the textured portion 41 comprises an unillustrated Ag layer for more effectively reflecting light. Thus, when the textured portion 41 is irradiated with light (chain double-dashed line in Fig. 7), the radiated light is diffusely reflected by inclined surfaces of convex portions 41a in textured portion 41. Then, the reflected light is reflected back by front cover 21 of solar cell 30, and enters front surface 30a of solar cell 30. In other words, a diffuse-reflection portion for diffusely reflecting light is formed on front surface 40a of diffuse reflection tab wiring 40. Back surface 40b of diffuse reflection tab wiring 40 is formed in a flat shape.

As shown in Figs. 4 and 6, solar cell group 23a is configured such that back surface 40b of each diffuse reflection tab wiring 40 is connected to front surface 30a of solar cell 30 on the Y2 side. Accordingly, textured portion 41 is formed on front surface 40a of diffuse reflection tab wiring 40 in a connection area to be connected to front surface 30a of solar cell 30 on the Y2 side.

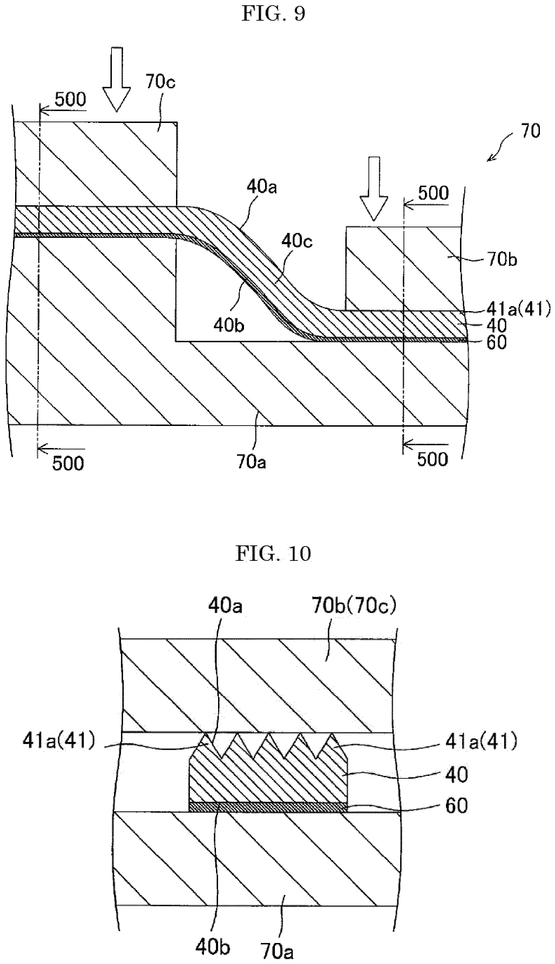

Diffuse reflection tab wiring 40 includes bent portion 40c inclined downward (Z2 side) from the Y2 side toward the Y1 side. Bent portion 40c is formed by use of a later-mentioned forming jig 70 (see Fig. 9) to connect back surface 30b of solar cell 30 on the Y1 side and front surface 30a of solar cell 30 on the Y2 side, or to connect transmitting wiring 25 on the Y1 side and solar cell 30 on the Y2 side.

Here, in the first embodiment, as shown in Figs. 7 and 8, an area of diffuse reflection tab wiring 40, where diffuse reflection tab wiring 40 is connected to back surface 30b of solar cell 30 (see Fig. 7) or to transmitting wiring 25 (see Fig. 8) disposed on the Y1 side, is formed with flat portion 42 having substantially flat surface 42a. Flat portion 42 is formed by crushing convex portions 41a of textured portion 41 to flatten convex portions 41a in the X direction to form substantially flat surface 42a which virtually does not have a texture or indentations. As shown in Figs. 4 and 6, flat portion 42 is formed in a plate shape having a uniform thickness in a Z direction from the vicinity of its Y1 side end portion to the vicinity of its Y2 side end portion.

Diffuse reflection tab wiring 40 is formed with stepped portion 40d at border region A between flat portion 42 and the portion (textured portion 41) other than flat portion 42. Hence, as shown in Fig. 7, a thickness t1 of flat portion 42 of diffuse reflection tab wiring 40 in the Z direction is smaller than a thickness t2 of textured portion 41 of diffuse reflection tab wiring 40 in the Z direction. In addition, a width W1 of flat portion 42 of diffuse reflection tab wiring 40 in the X direction is larger than a width W2 of textured portion 41 of diffuse reflection tab wiring 40 in the X direction.

Next, a method of forming flat portion 42 of diffuse reflection tab wiring 40 of the first embodiment of the invention is described with reference to Figs. 7 and 9 to 12. In the first embodiment, forming jig 70 for forming bent portion 40c in diffuse reflection tab wiring 40 is used to form flat portion 42 in diffuse reflection tab wiring 40. In other words, flat portion 42 is formed in diffuse reflection tab wiring 40 in a step of forming bent portion 40c in diffuse reflection tab wiring 40. Details are described below.

First, there is prepared diffuse reflection tab wiring 40 with no flat portion 42 (see Fig. 7) formed thereon but with uniform convex portions 41a of textured portion 41 formed on front surface 40a thereof. Note that solder 60 is formed as a layer on back surface 40b of diffuse reflection tab wiring 40.

Then, as shown in Fig. 9, diffuse reflection tab wiring 40 is placed between mount 70a and pressing members 70b and 70c of forming jig 70. Pressing surfaces of mount 70a and pressing member 70b which are opposite to each other are substantially flat and pressing surfaces of mount 70a and pressing member 70c which are opposite to each other are substantially flat.

Mount 70a includes a step at a position corresponding to a place in diffuse reflection tab wiring 40 where bent portion 40c is to be formed. Pressing member 70b is disposed in a place where flat portion 42 is to be formed, which is on one side of the place where bent portion 40c is to be formed. Meanwhile, pressing member 70c is disposed in a place where flat portion 42 is not to be formed on the other side of the place where the bent portion 40c is to be formed. Thereafter, pressing members 70b and 70c apply the substantially same pressure to diffuse reflection tab wiring 40, whereby the area for the bent portion 40c of diffuse reflection tab wiring 40 is bent to form bent portion 40c. At this time, as shown in Figs. 9 and 10, convex portions 41a of textured portion 41 are not substantially crushed in any place, and flat portion 42 is not formed yet.

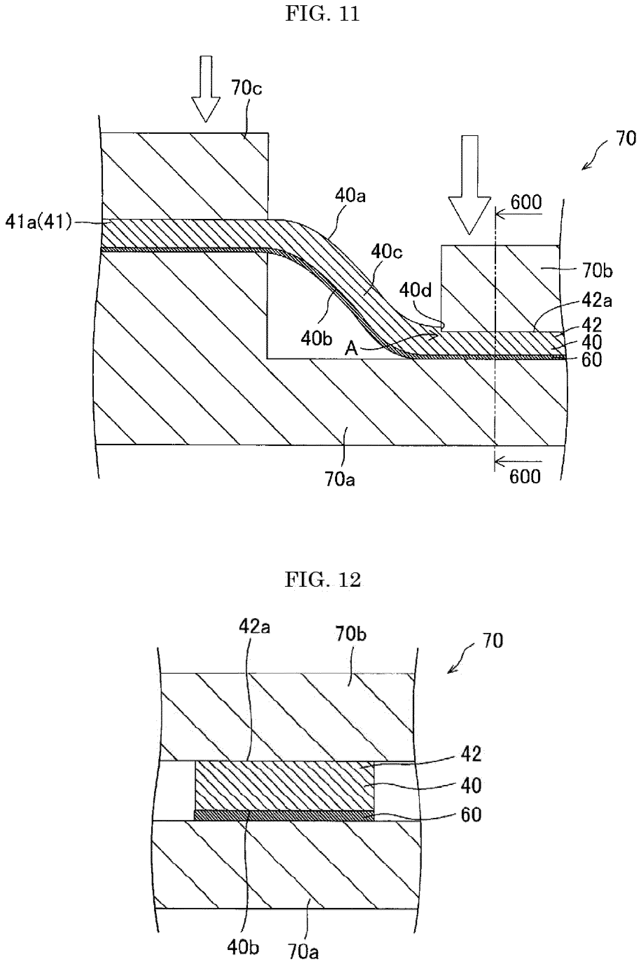

After forming bent portion 40c in diffuse reflection tab wiring 40, a pressure larger than that applied to form bent portion 40c in diffuse reflection tab wiring 40 is applied by pressing member 70b to diffuse reflection tab wiring 40 in the place where flat portion 42 is to be formed. Thus, as shown in Figs. 11 and 12, triangular cross sections of convex portions 41a in the place where flat portion 42 is to be formed are crushed to thereby form flat portion 42 which is substantially flat without the texture. At this time, pressing member 70b crushes diffuse reflection tab wiring 40 so that the width W1 (see Fig. 7) of flat portion 42 of diffuse reflection tab wiring 40 in the X direction becomes larger than the width W2 (see Fig. 7) of textured portion 41 of diffuse reflection tab wiring 40 in the X direction, while the thickness t1 (see Fig. 7) of flat portion 42 of diffuse reflection tab wiring 40 in the Z direction becomes smaller than the thickness t2 (see Fig. 7) of textured portion 41 of diffuse reflection tab wiring 40 in the Z direction.

As shown in Fig. 11, stepped portion 40d is also formed in border region A between flat portion 42 and the portion other than the flat portion 42. As described above, flat portion 42 is formed in diffuse reflection tab wiring 40. Note that thereafter, back surface 30b of solar cell 30 (transmitting wiring 25) and flat portion 42 of diffuse reflection tab wiring 40 are connected in a place a predetermined space away from stepped portion 40d of diffuse reflection tab wiring 40 toward the Y1 side, while front surface 30a of solar cell 30 (transmitting wiring 26) and back surface 40b of diffuse reflection tab wiring 40 are connected on the Y2 side of stepped portion 40d.

In the first embodiment, formed flat portion 42 of diffuse reflection tab wiring 40 which does not have the texture as described above enlarges the contact area between front surface 40a of diffuse reflection tab wiring 40 and back surface 30b of solar cell 30, as well as the contact area between front surface 40a of diffuse reflection tab wiring 40 and transmitting wiring 25. With this, it is possible to suppress lowering in the boding strength between diffuse reflection tab wiring 40 and solar cell 30, as well as the bonding strength between diffuse reflection tab wiring 40 and transmitting wiring 25, to thereby suppress decrease in yield.

In the first embodiment, the thickness t1 of flat portion 42 of diffuse reflection tab wiring 40 in the Z direction is made smaller than the thickness t2 of textured portion 41 of diffuse reflection tab wiring 40 in the Z direction as described above. With this configuration, when a pressure is applied to solar cell 30, for example, flat portion 42 having the small thickness t1 of diffuse reflection tab wiring 40 in the Z direction can prevent the pressure from being locally applied to a portion of solar cell 30 corresponding to the end portion of flat portion 42 of diffuse reflection tab wiring 40. Hence, it is possible to prevent the pressure from being locally applied to solar cell 30 so as to prevent breakage of solar cell 30. This increases the yield.

In the first embodiment, the width W1 of flat portion 42 of diffuse reflection tab wiring 40 in the X direction is larger than the width W2 of textured portion 41 of diffuse reflection tab wiring 40 in the X direction as described above. Thus, this enlarges the contact area between front surface 40a of diffuse reflection tab wiring 40 and back surface 30b of solar cell 30, as well as the contact area between front surface 40a of diffuse reflection tab wiring 40 and transmitting wiring 25. With this, it is possible to suppress lowering in the boding strength between diffuse reflection tab wiring 40 and solar cell 30, as well as the bonding strength between diffuse reflection tab wiring 40 and transmitting wiring 25. With this configuration, when a pressure is applied to solar cell 30 and transmitting wiring 25, for example, flat portion 42 having the large width W1 of diffuse reflection tab wiring 40 can more effectively prevent the pressure from being applied locally to the portion of solar cell 30 corresponding to the end portion of flat portion 42 of diffuse reflection tab wiring 40.

In the first embodiment, the triangular cross sections of convex portions 41a in the place where flat portion 42 is to be formed are crushed to thereby form flat portion 42 which is substantially flat without the texture as described above. Thus, diffuse reflection tab wiring 40 with the texture having different heights in the thickness direction can be made from a diffuse reflection tab wiring on which textured portion 41 is uniformly formed.

In the first embodiment, after forming bent portion 40c in diffuse reflection tab wiring 40, flat portion 42 is formed by applying a pressure larger than that applied to form bent portion 40c in diffuse reflection tab wiring 40 by pressing member 70b to the place in diffuse reflection tab wiring 40 where flat portion 42 is to be formed, as described above. Thus, since the texture in the place where flat portion 42 of diffuse reflection tab wiring 40 is to be formed can be crushed in the step of forming bent portion 40c in diffuse reflection tab wiring 40, no additional dedicated step for crushing the texture is required. Hence, an increase in manufacturing steps can be suppressed.

### (Second Embodiment)

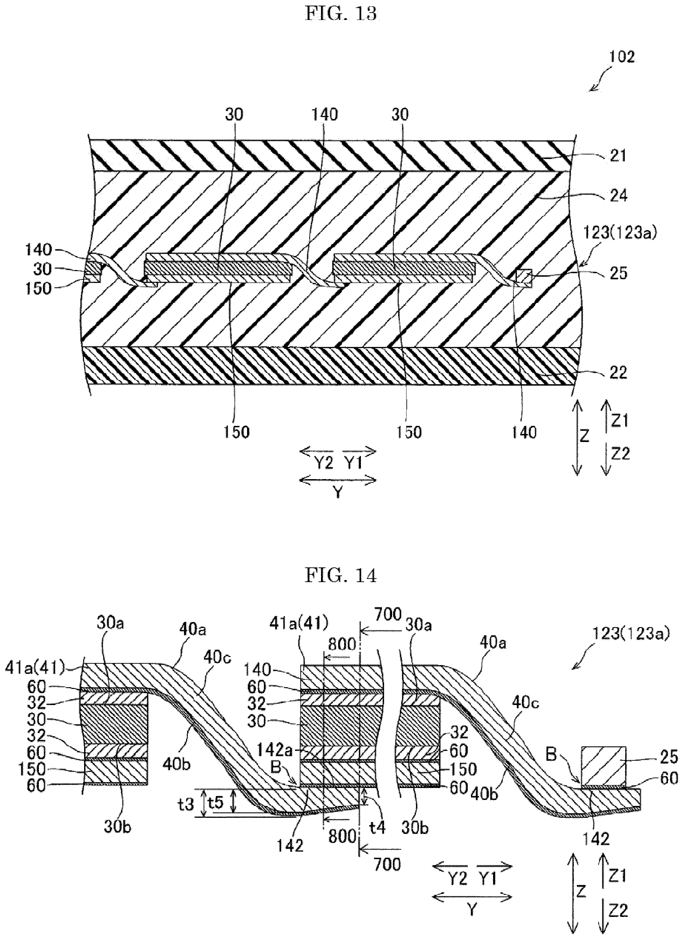

Next, a configuration of solar cell panel 102 of a second embodiment of the invention is described with reference to Figs. 13 to 18. The second embodiment describes an example in which, unlike the first embodiment, back-surface tab electrode 150 is disposed on back surface 30b of solar cell 30 in solar cell group 123a, to connect back-surface tab electrode 150 and inclined portion 142 of diffuse reflection tab wiring 140.

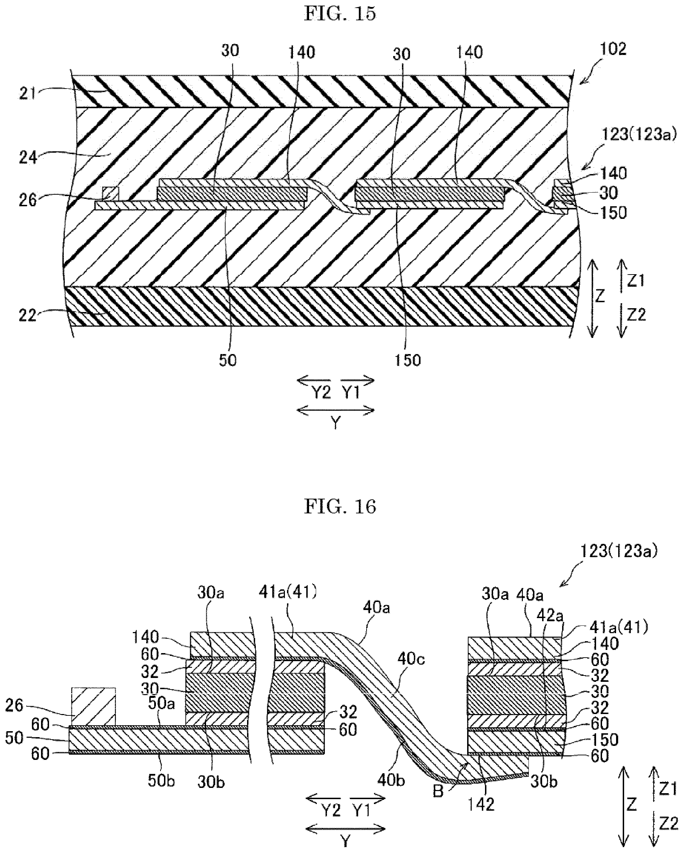

As shown in Figs. 13 to 16, in solar cell group 123a of solar cell panel 102 of the second embodiment, plate-shaped back-surface tab electrode 150 is disposed on a back surface of bus bar electrode 32 (see Figs. 14 and 16) which is disposed on back surface 30b of solar cell 30. Back-surface tab electrode 150 is disposed along a direction in which bus bar electrode 32 extends (Y direction), from the vicinity of an end portion on a Y1 side of solar cell 30 to the vicinity of an end portion on a Y2 side thereof. Note that back-surface tab electrode 150 is an example of "back-surface wiring material" of the invention.

As shown in Figs. 14 and 16, back-surface tab electrode 150 on back surface 30b of solar cell 30 on the Y1 side is connected bus bar electrode 32 on front surface 30a of solar cell 30 on the Y2 side, with diffuse reflection tab wiring 140 having solder 60 in between. In addition, as shown in Fig. 14, transmitting wiring 25 disposed in the Y1 side end portion is connected to bus bar electrode 32 disposed on front surface 30a of solar cell 30 located in the Y1 side end portion of solar cell group 123a, with diffuse reflection tab wiring 140.

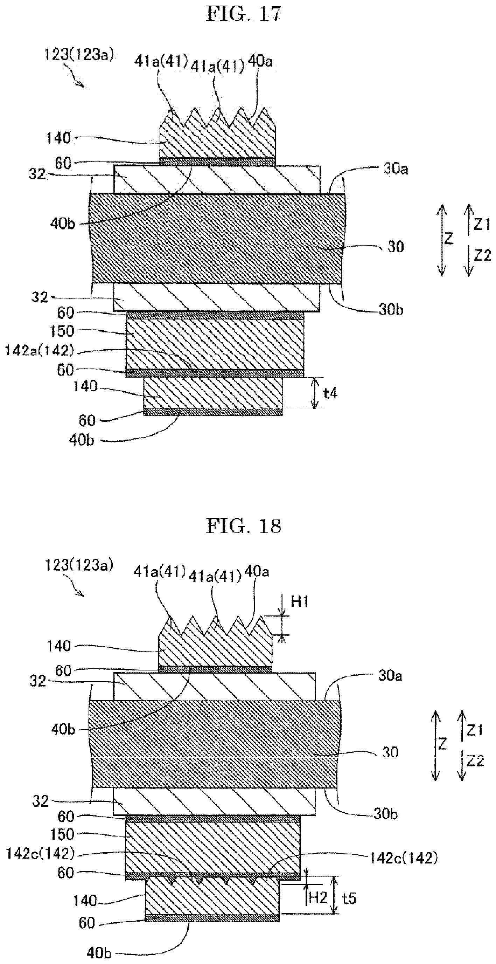

Here, in the second embodiment, as shown in Figs. 14 and 16, inclined portion 142 is provided to each of diffuse reflection tab wiring 140 connected to back-surface tab electrode 150 and diffuse reflection tab wiring 140 connected to transmitting wiring 25 (see Fig. 14). As shown in Fig. 17, substantially flat surface 142a is formed in inclined portion 142 of diffuse reflection tab wiring 140 in the end portion on the Y1 side (see Fig. 16). Meanwhile, as shown in Fig. 18, in diffuse reflection tab wiring 140, multiple trapezoidal portions 142c are adjacently formed in inclined portion 142 of diffuse reflection tab wiring 140, in an area located between the end portion on the Y1 side and a border region B (see Fig. 16) between inclined portion 142 and the portion other than inclined portion 142 (textured portion 41). In multiple trapezoidal portions 142c, parts near apexes of triangular cross sections of convex portions 41a in textured portion 41 from border region B to the vicinity of the end portion on the Y1 side are crushed and the parts near the apexes of triangles are made flat, so that trapezoidal cross sections are formed.

Moreover, inclined portion 142 is formed such that heights of multiple trapezoidal portions 142c in a Z direction are gradually reduced from border region B toward the Y1 side being the inclined portion 142 side. Specifically, in inclined portion 142, convex portions 41a (see Fig. 18) of textured portion 41 having heights H1 in the Z direction are formed in border region B on the Y2 side. Meanwhile, substantially flat surface 142a (see Fig. 17) having substantially no height in the Z direction is formed in the end portion on the Y1 side. Additionally, multiple trapezoidal portions 142c (see Fig. 18) are formed in inclined portion 142 between the end portion on the Y1 side and border region B, and heights H2 of trapezoidal portions 142c in the Z direction are gradually reduced toward the Y1 side. Accordingly, as shown in Fig. 14, diffuse reflection tab wiring 140 is formed such that a thickness t3 of border region B in diffuse reflection tab wiring 140 in the Z direction is larger than a thickness t4 of the end portion on the Y1 side in diffuse reflection tab wiring 140 in the Z direction, while a thickness t5 between the end portion on the Y1 side and border region B in the Z direction of diffuse reflection tab wiring 140 is smaller than the thickness t3 in border region B and larger than the thickness t4in the end portion on the Y1 side.

In the second embodiment, as shown in Figs. 14 and 16, back-surface tab electrode 150 and inclined portion 142 formed on front surface 40a of diffuse reflection tab wiring 140 on the front surface 40a side are connected in an end portion region of solar cell 30 on the Y2 side. To be specific, unlike diffuse reflection tab wiring 40 of the aforementioned first embodiment, diffuse reflection tab wiring 140 is disposed only in the end portion region on the Y2 side. Note that other parts of the configuration of the second embodiment are the same as the aforementioned first embodiment.

A method of forming diffuse reflection tab wiring 140 of the second embodiment is similar to the aforementioned first embodiment, except that an unillustrated forming jig is used. The forming jig includes a pressing surface corresponding to an inclination of inclined portion 142 of diffuse reflection tab wiring 140.

In the second embodiment, inclined portion 142 is formed such that the heights of multiple trapezoidal portions 142c in the Z direction are gradually reduced from border region B toward the Y1 side being the inclined portion 142 side, as described above. This makes it possible to prevent the thickness t3 of border region B in the Z direction from being formed small, which in turn prevents lowering in the mechanical strength of border region B where stress tends to concentrate. Thus, breakage of border region B due to stress concentration can be prevented.

In the second embodiment, back-surface tab electrode 150 is disposed on back surface 30b of solar cell 30, while back-surface tab electrode 150 of solar cell 30 and inclined portion 142 formed on the front surface 40a side of diffuse reflection tab wiring 140 are connected in the end portion region on the Y2 side, as described above. With this configuration, diffuse reflection tab wiring 140 to be connected to back-surface tab electrode 150 does not need to be disposed in a large area on back surface 30b of solar cell 30, and thus only a small region is necessary to form inclined portion 142. Thus, inclined portion 142 can be formed easily. Note that other effects of the second embodiment are similar to the aforementioned first embodiment.

It should be noted that the embodiments disclosed herein are illustrative in every respect, and is not limitative. The scope of the invention is defined not by the above description of embodiments but by the scope of claims, and includes all modifications within the meaning and range of equivalents of the scope of claims.

For example, the aforementioned first and second embodiments describe examples in which flat portion 42 of diffuse reflection tab wiring 40 and inclined portion 142 of diffuse reflection tab wiring 140 are formed by crushing convex portions 41a of textured portion 41 by use of a forming jig. However, the invention is not limited to these examples. The height of the texture of the flat portion and the inclined portion in the thickness direction may be made small by causing the convex portions of the diffuse-reflection portion to melt by heat, for example. Alternatively, the height of the texture of the flat portion and the inclined portion in the thickness direction may be made small by using both pressure and heat. Otherwise, the height of the texture of the flat portion and the inclined portion in the thickness direction may be made small by scraping away the apexes of the texture (triangular shapes).

The aforementioned first embodiment describes an example in which plate-shaped flat portion 42 having uniform thickness from the vicinity of the Y1 side to the vicinity of the Y2 side is formed in diffuse reflection tab wiring 40, in the connection portion to be connected to back surface 30b of solar cell 30 on the Y1 side. However, the invention is not limited to this example. The connection portion to be connected to the back surface of the solar cell on the Y1 side in diffuse reflection tab wiring may be formed such that its thickness in the Z direction is gradually reduced from the vicinity of the Y1 side end portion toward the vicinity of the Y2 side end portion, for example.

The aforementioned second embodiment describes an example in which back-surface tab electrode 150 and inclined portion 142 of diffuse reflection tab wiring 140 are connected in the end portion region on the Y2 side. However, the invention is not limited to this example. In the invention, the back-surface tab electrode and the diffuse reflection tab wiring may be connected to substantially the entire region where the back-surface tab electrode is disposed.

The second embodiment describes the example in which back-surface tab electrode 150 and inclined portion 142 of diffuse reflection tab wiring 140are connected in the end portion region on the Y2 side. However, the invention is not limited to this example. In the invention, diffuse reflection tab wiring to be connected to the back-surface tab electrode in the connection region may be formed in a plate shape with no inclination.

The aforementioned first and second embodiments describe examples in which flat portion 42 of diffuse reflection tab wiring 40 and inclined portion 142 of diffuse reflection tab wiring 140 are formed by crushing convex portions 41a of textured portion 41 by use of a forming jig. However, the invention is not limited to these examples. In the invention, the convex portions of the textured portion may be crushed not by use of a forming jig but by use of a tool such as a cutting plier, a press tool, or the like. Alternatively, another step may be added for crushing the convex portions of the textured portion.

The aforementioned first embodiment describes an example in which flat portion 42 which is substantially flat is formed by applying a pressure larger than that applied to form bent portion 40c in diffuse reflection tab wiring 40 by pressing member 70b to the place in diffuse reflection tab wiring 40 where flat portion 42 is to be formed. However, the invention is not limited to this example. The invention may employ a jig adjusted such that a space between the pressing member and the mount in a place corresponding to the flat portion is made smaller than a space between the pressing member and the mount in a place corresponding to the portion other than the flat portion. This configuration makes it possible to form the flat portion and the bent portion in the diffuse reflection tab wiring by a single pressing operation.

The aforementioned first embodiment describes an example in which the width W1 of flat portion 42 in diffuse reflection tab wiring 40 in the X direction is made larger than the width W2 of textured portion 41 in diffuse reflection tab wiring 40 in the X direction, while the thickness t1 of flat portion 42 in diffuse reflection tab wiring 40 in the Z direction is made smaller than the thickness t2 of textured portion 41 in diffuse reflection tab wiring 40 in the Z direction. However, the invention is not limited to this example. In the invention, the width of the flat portion in the diffuse reflection tab wiring need not be made larger than the width of the textured portion in the diffuse reflection tab wiring, and the thickness of the flat portion in the diffuse reflection tab wiring need not be made smaller than the textured portion in the thickness of the diffuse reflection tab wiring.

## Claims

1. A solar cell module (1) comprising:
a first solar cell (30) and a second solar cell (30) disposed adjacent to each other; and
a diffuse reflection wiring material (40) including a front surface (40a) in which a textured diffuse-reflection portion (41) for diffusely reflecting light is formed and a back surface (40b), the back surface (40b) being connected to a front surface side (30a) of the first solar cell (30), the front surface (40a) being connected to one of a back surface (30b) of the second solar cell (30) and an intermediate wiring material (25),
**characterized in that**:
the diffuse-reflection portion (41) in a first connection area where the diffuse reflection wiring material (40) is connected to the one of the back surface (30b) of the second solar cell (30) and the intermediate wiring material (25) has a smaller height of the texture in a thickness direction than the diffuse-reflection portion (41) in a bent portion (40c) of the diffuse reflection wiring material (40) and the diffuse-reflection portion (41) in a second connection area where the diffuse reflection wiring material (40) is connected to the front surface (30a) of the first solar cell (30).

2. The solar cell module (1) according to claim 1, wherein the diffuse reflection wiring material (40) in the first connection area where the diffuse reflection wiring material (40) is connected to the one of the back surface (30b) of the second solar cell (30) and the intermediate wiring material (25) has a smaller thickness than the diffuse reflection wiring material (40) in the second connection area where the diffuse reflection wiring material (40) is connected to the front surface (30a) of the first solar cell (30).

3. The solar cell module (1) according to claim 2, wherein the diffuse reflection wiring material (40) in the first connection area where the diffuse reflection wiring material (40) is connected to the one of back surface (30b) of the second solar cell (30) and the intermediate wiring material (25) has a larger width in a direction orthogonal to a direction in which the diffuse reflection wiring material (40) extends, than the diffuse reflection wiring material (40) in the second connection area where the diffuse reflection wiring material (40) is connected to the front surface (30a) of the first solar cell (30).

4. The solar cell module (1) according to any one of claims 1 to 3, wherein a thickness of the diffuse reflection wiring material (40) is gradually reduced from a border region (A) where the diffuse-reflection portion (41) is changed to have the texture with a smaller height, to a side where the diffuse-reflection portion (41) has the texture with smaller height.

5. The solar cell module (1) according to any one of claims 1 to 4, further comprising a plate-shaped back-surface wiring material (150) connected to the back surface (30b) of the second solar cell (30), wherein
the front surface (40a) of the diffuse reflection wiring material (40) is connected to the back surface (30b) of the second solar cell (30) by being connected to the back-surface wiring material (150) disposed on the back surface (30b) of the second solar cell (30).

6. A method of manufacturing a solar cell module (1) including a first solar cell (30) and a second solar cell (30) disposed adjacent to each other, and a diffuse reflection wiring material (40) having a front surface (40a) on which a textured diffuse-reflection portion (41) for diffusely reflecting light is formed and a back surface (40b), the back surface (40b) being connected to a front surface side (30a) of the first solar cell (30), the front surface (40a) being connected to one of a back surface (30b) of the second solar cell (30) and an intermediate wiring material (25),
**characterized in that** the method comprises the steps of:
crushing the texture in a predetermined area of the diffuse-reflection portion (41) by applying at least one of pressure and heat, such that the texture in the predetermined area approximates a flat surface; and
connecting the one of the back surface (30b) of the second solar cell and the intermediate wiring material (25) to the front surface (40a) of the diffuse reflection wiring material (40) in the area where the texture of the diffuse-reflection portion (41) is crushed, while connecting the front surface (30a) of the first solar cell (30) and the back surface (40b) of the diffuse reflection wiring material (40) in an area where the texture of the diffuse-reflection portion (41) is not crushed.

7. The method of manufacturing a solar cell module (1) according to claim 6, further comprising a step of bending the diffuse reflection wiring material (40) into a predetermined shape for connecting the front surface (30a) of the first solar cell (30) and the back surface (30b) of the second solar cell (30), wherein
the step of crushing the texture in the predetermined area of the diffuse-reflection portion (41) is performed in the step of bending the diffuse reflection wiring material (40).

8. The method of manufacturing a solar cell module (1) according to claim 7, wherein the step of bending the diffuse reflection wiring material (40) comprises a step of bending the diffuse reflection wiring material (40) by applying a first pressure, and then crushing the texture in the predetermined area of the diffuse-reflection portion (41) by applying a second pressure larger than the first pressure to the predetermined area of the diffuse-reflection portion (41).

9. The method of manufacturing a solar cell module (1) according to any one of claims 6 to 8, further comprising a step of connecting the back surface (30b) of the second solar cell (30) and a plate-shaped back-surface wiring material (150), wherein
the step of connecting the back surface (30b) of the second solar cell (30) and the front surface (40a) of the diffuse reflection wiring material (40) comprises a step of connecting the plate-shaped back-surface wiring material (150) and the front surface (40a) of the diffuse reflection wiring material (40) in the area where the texture of the diffuse-reflection portion (41) is crushed.

## Patentansprüche

1. Solarzellmodul (1), das Folgendes umfasst:
eine erste Solarzelle (30) und eine zweite Solarzelle (30), die aneinander angrenzend angeordnet sind; und
ein diffus reflektierendes Verdrahtungsmaterial (40), das Folgendes umfasst: eine vordere Oberfläche (40a), in der ein diffus reflektierender texturierter Abschnitt (41) ausgebildet ist, um Licht diffus zu reflektieren, und eine hintere Oberfläche (40b), wobei die hintere Oberfläche (40b) mit der Seite einer vorderen Oberfläche (30a) der ersten Solarzelle (30) verbunden ist, wobei die vordere Oberfläche (40a) mit einer hinteren Oberfläche (30b) der zweiten Solarzelle (30) oder einem Zwischenverdrahtungsmaterial (25) verbunden ist,
**dadurch gekennzeichnet, dass**:
der diffus reflektierende Abschnitt (41) in einem ersten Verbindungsbereich, in der das diffus reflektierende Verdrahtungsmaterial (40) mit der hinteren Oberfläche (30b) der zweiten Solarzelle (30) oder dem Zwischenverdrahtungsmaterial (25) verbunden ist, in einer Dickerichtung eine geringere Texturhöhe aufweist als der diffus reflektierende Abschnitt (41) ein einem gebogenen Abschnitt (40c) des diffus reflektierenden Verdrahtungsmaterials (40) und der diffus reflektierende Abschnitt (41) in einem zweiten Verbindungsbereich, in dem das diffus reflektierende Verdrahtungsmaterial (40) mit der vorderen Oberfläche (30a) der ersten Solarzelle (30) verbunden ist.

2. Solarzellmodul (1) nach Anspruch 1, wobei das diffus reflektierende Verdrahtungsmaterial (40) in dem ersten Verbindungsbereich, in dem das diffus reflektierende Verdrahtungsmaterial (40) mit der hinteren Oberfläche (30b) der zweiten Solarzelle (30) oder dem Zwischenverdrahtungsmaterial (25) verbunden ist, in einer Dickerichtung eine geringere Texturhöhe aufweist als das diffus reflektierende Verdrahtungsmaterial (40) in dem zweiten Verbindungsbereich, in dem das diffus reflektierende Verdrahtungsmaterial (40) mit der vorderen Oberfläche (30a) der ersten Solarzelle (30) verbunden ist.

3. Solarzellmodul (1) nach Anspruch, wobei das diffus reflektierende Verdrahtungsmaterial (40) in dem ersten Verbindungsbereich, in dem das diffus reflektierende Verdrahtungsmaterial (40) mit der hinteren Oberfläche (30b) der zweiten Solarzelle (30) oder dem Zwischenverdrahtungsmaterial (25) verbunden ist, in einer Richtung, die im rechten Winkel auf eine Richtung steht, in der sich das diffus reflektierende Verdrahtungsmaterial (40) erstreckt, eine größere Breite aufweist als das diffus reflektierende Verdrahtungsmaterial (40) in dem zweiten Verbindungsbereich, in dem das diffus reflektierende Verdrahtungsmaterial (40) mit der vorderen Oberfläche (30a) der ersten Solarzelle (30) verbunden ist.

4. Solarzellmodul (1) nach einem der Ansprüche 1 bis 3, wobei die Dicke des diffus reflektierenden Verdrahtungsmaterials (40) von einem Randbereich (A), in dem der diffus reflektierende Abschnitt (41) so verändert ist, dass er die Textur mit geringerer Höhe aufweist, hin zu einer Seite, wo der diffus reflektierende Abschnitt (41) die Textur mit geringerer Höhe aufweist, allmählich reduziert wird.

5. Solarzellmodul (1) nach einem der Ansprüche 1 bis 4, das ferner ein plattenförmiges Verdrahtungsmaterial (150) auf der hinteren Oberfläche umfasst, das mit der hinteren Oberfläche (30b) der zweiten Solarzelle (30) verbunden ist, wobei
die vordere Oberfläche (40a) des diffus reflektierenden Verdrahtungsmaterials (40) mit der hinteren Oberfläche (30b) der zweiten Solarzelle (30) verbunden ist, indem sie mit dem Verdrahtungsmaterial (150) auf der hinteren Oberfläche verbunden ist, das auf der hinteren Oberfläche (30b) der zweiten Solarzelle (30) angeordnet ist.

6. Verfahren zur Herstellung eines Solarzellmoduls (1), das Folgendes umfasst:
eine erste Solarzelle (30) und eine zweite Solarzelle (30), die aneinander angrenzend angeordnet sind; und
ein diffus reflektierendes Verdrahtungsmaterial (40), das Folgendes umfasst: eine vordere Oberfläche (40a), auf der ein diffus reflektierender texturierter Abschnitt (41) ausgebildet ist, um Licht diffus zu reflektieren, und eine hintere Oberfläche (40b), wobei die hintere Oberfläche (40b) mit einer Seite einer vorderen Oberfläche (30a) der ersten Solarzelle (30) verbunden ist, wobei die vordere Oberfläche (40a) mit einer hinteren Oberfläche (30b) der zweiten Solarzelle (30) oder einem Zwischenverdrahtungsmaterial (25) verbunden ist,
**dadurch gekennzeichnet, dass** das Verfahren folgende Schritte umfasst:
das Aufbrechen der Textur in einem vorbestimmten Bereich des diffus reflektierenden Abschnitts (41) durch Ausüben von zumindest einem von Druck und Hitze, so dass sich die Textur in dem vorbestimmten Abschnitt einer flachen Oberfläche annähert, und
das Verbinden der hinteren Oberfläche (30b) der zweiten Solarzelle oder des Zwischenverdrahtungsmaterials (25) mit der vorderen Oberfläche (40a) des diffus reflektierenden Verdrahtungsmaterials (40) in dem Bereich, in dem die Textur des diffus reflektierenden Abschnitts (41) aufgebrochen ist, während die vordere Oberfläche (30a) der ersten Solarzelle (30) und die hintere Oberfläche (40b) des diffus reflektierenden Verdrahtungsmaterials (40) in einem Bereich verbunden werden, in dem die Textur des diffus reflektierenden Abschnitts (41) nicht aufgebrochen ist.

7. Verfahren zur Herstellung eines Solarzellmoduls (1) nach Anspruch 6, das ferner einen Schritt des Biegens des diffus reflektierenden Verdrahtungsmaterials (40) in eine vorbestimmte Form umfasst, um die vordere Oberfläche (30a) der ersten Solarzelle (30) und die hintere Oberfläche (30b) der zweiten Solarzelle (30) zu verbinden, wobei
der Schritt des Aufbrechens der Textur in dem vorbestimmten Bereich des diffus reflektierenden Abschnitts (41) im Zuge des Schritts des Biegens des diffus reflektierenden Verdrahtungsmaterials (40) durchgeführt wird.

8. Verfahren zur Herstellung eines Solarzellmoduls (1) nach Anspruch 7, wobei der Schritt des Biegens des diffus reflektierenden Verdrahtungsmaterials (40) einen Schritt des Biegens des diffus reflektierenden Verdrahtungsmaterials (40) durch das Ausüben eines ersten Drucks und das anschließende Aufbrechen der Textur in dem vorbestimmten Bereich des diffus reflektierenden Abschnitts (41) durch das Ausüben eines zweiten Drucks, der höher ist als der erste Druck, auf den vorbestimmten Bereich des diffus reflektierenden Abschnitts (41) umfasst.

9. Verfahren zur Herstellung eines Solarzellmoduls (1) nach einem der Ansprüche 6 bis 8, das ferner einen Schritt des Verbindens der hinteren Oberfläche (30b) der zweiten Solarzelle (30) und eines plattenförmigen Verdrahtungsmaterials (150) auf der hinteren Oberfläche umfasst, wobei
der Schritt des Verbindens der hinteren Oberfläche (30b) der zweiten Solarzelle (30) und der vorderen Oberfläche (40a) des diffus reflektierenden Verdrahtungsmaterials (40) einen Schritt des Verbindens des plattenförmigen Verdrahtungsmaterials (150) auf der hinteren Oberfläche und der vorderen Oberfläche (40a) des diffus reflektierenden Verdrahtungsmaterials (40) in dem Bereich umfasst, wo die Textur des diffus reflektierenden Abschnitts (41) aufgebrochen ist.

## Revendications

1. Module de cellule solaire (1) comprenant :
une première cellule solaire (30) et une seconde cellule solaire (30) disposées de manière adjacente l'une à l'autre ; et
un matériau de câblage à réflexion diffuse (40) comprenant une surface avant (40a) sur laquelle une partie de réflexion diffuse texturée (41) destinée à réfléchir la lumière de manière diffuse est formée, et une surface arrière (40b), la surface arrière (40b) étant reliée à une surface avant (30a) de la première cellule solaire (30), la surface avant (40a) étant reliée à l'un d'une surface arrière (30b) de la seconde cellule solaire (30) et d'un matériau de câblage intermédiaire (25),
**caractérisé en ce que** :
la partie de réflexion diffuse (41) dans une première zone de liaison dans laquelle le matériau de câblage à réflexion diffuse (40) est relié à l'un de la surface arrière (30b) de la seconde cellule solaire (30) et du matériau de câblage intermédiaire (25) possède une hauteur de texture dans une direction d'épaisseur inférieure à la partie de réflexion diffuse (41) dans une partie de cintrage (40c) du matériau de câblage à réflexion diffuse (40) et à la partie de réflexion diffuse (41) dans une seconde zone de liaison dans laquelle le matériau de câblage à réflexion diffuse (40) est relié à la surface avant (30a) de la première cellule solaire (30).

2. Module de cellule solaire (1) selon la revendication 1, dans lequel le matériau de câblage à réflexion diffuse (40) dans la première zone de liaison dans laquelle le matériau de câblage à réflexion diffuse (40) est relié à l'un de la surface arrière (30b) de la seconde cellule solaire (30) et du matériau de câblage intermédiaire (25) possède une épaisseur inférieure au matériau de câblage à réflexion diffuse (40) dans la seconde zone de liaison dans laquelle le matériau de câblage à réflexion diffuse (40) est relié à la surface avant (30a) de la première cellule solaire (30).

3. Module de cellule solaire (1) selon la revendication 2, dans lequel le matériau de câblage à réflexion diffuse (40) dans la première zone de liaison dans laquelle le matériau de câblage à réflexion diffuse (40) est relié à l'un de la surface arrière (30b) de la seconde cellule solaire (30) et du matériau de câblage intermédiaire (25) présente une largeur plus importante dans une direction orthogonale par rapport à une direction dans laquelle le matériau de câblage à réflexion diffuse (40) s'étend, que le matériau de câblage à réflexion diffuse (40) dans la seconde zone de liaison dans laquelle le matériau de câblage à réflexion diffuse (40) est relié à la surface avant (30a) de la première cellule solaire (30).

4. Module de cellule solaire (1) selon l'une quelconque des revendications 1 à 3, dans lequel une épaisseur du matériau de câblage à réflexion diffuse (40) est progressivement réduite entre une zone de bordure (A) dans laquelle la partie de réflexion diffuse (41) est modifiée afin d'avoir la texture à hauteur réduite, et un côté au niveau duquel la partie de réflexion diffuse (41) présente la texture à hauteur réduite.

5. Module de cellule solaire (1) selon l'une quelconque des revendications 1 à 4, comprenant en outre un matériau de câblage de surface arrière en forme de plaque (150) relié à la surface arrière (30b) de la seconde cellule solaire (30), dans lequel
la surface avant (40a) du matériau de câblage à réflexion diffuse (40) est reliée à la surface arrière (30b) de la seconde cellule solaire (30) en étant reliée au matériau de câblage de surface arrière (150) disposé sur la surface arrière (30b) de la seconde cellule solaire (30).

6. Procédé de fabrication d'un module de cellule solaire (1) comprenant une première cellule solaire (30) et une seconde cellule solaire (30) disposées de manière adjacente l'une à l'autre, et un matériau de câblage à réflexion diffuse (40) ayant une surface avant (40a) sur laquelle une partie de réflexion diffuse texturée (41) destinée à réfléchir la lumière de manière diffuse est formée et une surface arrière (40b), la surface arrière (40b) étant reliée à une surface avant (30a) de la première cellule solaire (30), la surface avant (40a) étant reliée à l'un d'une surface arrière (30b) de la seconde cellule solaire (30) et d'un matériau de câblage intermédiaire (25),
**caractérisé en ce que** le procédé comprend les étapes consistant à :
écraser la texture dans une zone prédéterminée de la partie de réflexion diffuse (41) en appliquant au moins l'une d'une pression et d'une chaleur, de sorte que la texture dans la zone prédéterminée s'approche d'une surface plane ; et
relier l'un de la surface arrière (30b) de la seconde cellule solaire et du matériau de câblage intermédiaire (25) à la surface avant (40a) du matériau de câblage à réflexion diffuse (40) dans la zone dans laquelle la texture de la partie de réflexion diffuse (41) est écrasée, tout en reliant la surface avant (30a) de la première cellule solaire (30) et la surface arrière (40b) du matériau de câblage à réflexion diffuse (40) dans une zone dans laquelle la texture de la partie de réflexion diffuse (41) n'est pas écrasée.

7. Procédé de fabrication d'un module de cellule solaire (1) selon la revendication 6, comprenant en outre une étape de cintrage du matériau de câblage à réflexion diffuse (40) en une forme prédéterminée afin de relier la surface avant (30a) de la première cellule solaire (30) et la surface arrière (30b) de la seconde cellule solaire (30), dans lequel
l'étape d'écrasement de la texture dans la zone prédéterminée de la partie de réflexion diffuse (41) est effectuée lors de l'étape de cintrage du matériau de câblage à réflexion diffuse (40).

8. Procédé de fabrication d'un module de cellule solaire (1) selon la revendication 7, dans lequel l'étape de cintrage du matériau de câblage à réflexion diffuse (40) comprend une étape de cintrage du matériau de câblage à réflexion diffuse (40) en appliquant une première pression, puis d'écrasement de la texture dans la zone prédéterminée de la partie de réflexion diffuse (41) en appliquant une seconde pression supérieure à la première pression à la zone prédéterminée de la partie de réflexion diffuse (41).

9. Procédé de fabrication d'un module de cellule solaire (1) selon l'une quelconque des revendications 6 à 8, comprenant en outre une étape de liaison de la surface arrière (30b) de la seconde cellule solaire (30) et d'un matériau de câblage de surface arrière en forme de plaque (150), dans lequel
l'étape de liaison de la surface arrière (30b) de la seconde cellule solaire (30) et de la surface avant (40a) du matériau de câblage à réflexion diffuse (40) comprend une étape de liaison du matériau de câblage de surface arrière en forme de plaque (150) et de la surface avant (40a) du matériau de câblage à réflexion diffuse (40) dans la zone dans laquelle la texture de la partie de réflexion diffuse (41) est écrasée.
